# EUROPEAN PATENT SPECIFICATION

(11) **EP 2 930 852 B1**
(45) Date of publication and mention of the grant of the patent: **06.11.2019**
(21) Application number: 15162857.5
(22) Date of filing: 08.04.2015
(51) Int. Cl.: H03M 13/29, H04L 1/00, H04L 1/16

(54) **CONSTRUCTING A RELIABLE DATA STREAM**
HERSTELLUNG EINES ZUVERLÄSSIGEN DATENSTROMS
CONSTRUCTION D'UN FLUX DE DONNÉES FIABLE

(30) Priority: 09.04.2014 GB 201406410
(43) Date of publication of application: 14.10.2015
(73) Proprietor: Huawei Technologies Co., Ltd., Shenzhen 518129 (CN)
(72) Inventor: Smith, Peter, Histon, cambridgeshire CB24 9AD (GB)
(74) Representative: Gill Jennings & Every LLP

(56) References cited:
- US-A1- 2003 002 502
- US-A1- 2006 195 756
- LIN CHUNYU ET AL: "Multiple description video coding based on forward error correction within expanding windows", 2013 IEEE INTERNATIONAL CONFERENCE ON IMAGE PROCESSING, IEEE, 15 September 2013 (2013-09-15), pages 1909-1913, XP032565567, DOI: 10.1109/ICIP.2013.6738393 [retrieved on 2014-02-11]
- ZHI LI ET AL: "Forward and retransmitted Systematic Lossy Error Protection for IPTV video multicast", PACKET VIDEO WORKSHOP, 2009. PV 2009. 17TH INTERNATIONAL, IEEE, PISCATAWAY, NJ, USA, 11 May 2009 (2009-05-11), pages 1-9, XP031483135, ISBN: 978-1-4244-4651-3
- RAZAVI R ET AL: "H.264 video streaming with data-partitioning and Growth codes", IMAGE PROCESSING (ICIP), 2009 16TH IEEE INTERNATIONAL CONFERENCE ON, IEEE, PISCATAWAY, NJ, USA, 7 November 2009 (2009-11-07), pages 909-912, XP031628716, ISBN: 978-1-4244-5653-6
- LAITH AL-JOBOURI ET AL: "Robust data-partitioned video streaming over a WiMAX channel", WIRELESS AND MOBILE COMPUTING, NETWORKING AND COMMUNICATIONS (WIMOB), 2010 IEEE 6TH INTERNATIONAL CONFERENCE ON, IEEE, PISCATAWAY, NJ, USA, 11 October 2010 (2010-10-11), pages 406-413, XP031807943, ISBN: 978-1-4244-7743-2

## Description

This invention relates to transmitting parity information in a communication network to assist a receiving device to recover messages that it did not receive successfully.

Radio systems that are very limited in bandwidth could make use of a probabilistic acknowledgement scheme. In a probabilistic acknowledgement scheme, each packet is acknowledged, but some acknowledgements are false positives. Other systems are unable to provide definitive acknowledgements for received messages, due to the unreliable nature of radio communications.

This unreliable acknowledgement results in a number of messages potentially never being successfully transferred. Therefore there is a need for an improved mechanism for constructing a reliable data stream.

Razavi R et al: "H.264 video streaming with data-partitioning and Growth codes", IMAGE PROCESSING (ICIP), 2009 16TH IEEE INTERNATIONAL CONFERENCE ON, pages 909-912, ISBN: 978-1-4244-5653-6, November 2009 (2009-11-07) discloses growth codes in conjunction with H.264/AVC data partitioning allowing incremental protection.

The scope of protection of the present invention is defined by the appended claims 1-9. In the following description, any embodiment(s) referred to and not falling within the scope of the appended claims, is (are) merely example(s) useful to the understanding of the invention.

According to a first embodiment, there is provided a communication device configured to transmit a first parity message to another communication device for a group of one or more messages that the communication device has transmitted to the other communication device, the parity message including parity information from which the other communication device can reconstruct the one or more messages, and transmit a second parity message to the other communication device for a group of one or more subsequent messages that the communication device has transmitted to the other communication device, the communication device being configured to form the second parity message to overlap the first parity message by including in the second parity message parity information in respect of at least one message for which parity information is included in both the first and second parity messages, wherein the communication device is configured to form each of the multiple parity messages using a different error-correcting code.

A communication device as claimed in claim 1, configured to periodically: identify one or more messages that it has transmitted to the other communication device and for which it has not received an acknowledgement; and transmit a parity message for the group of identified messages.

The communication device may be configured to form the parity information such that it includes information from each message in a group of messages.

The communication device may be configured to form the parity information using a systematic block code.

The communication device may be configured to form the parity information using a continuous code.

The communication device may be configured to form the parity information using a block code that is maximum-distance-separable.

The communication device may be configured to transmit multiple parity messages in respect of the same group of messages.

The communication device may be configured to transmit the multiple parity messages until an acknowledgement is received from the other communication device for the group of messages.

The communication device may be configured to form each of the multiple parity messages using a different error-correcting code.

The communication device may be configured to designate a message as a key message.

The communication device may be configured to transmit a message that is designated as a key message with higher reliability than a message that is not designated as a key message.

The communication device may be configured to generate a comparison between the key message and transmit that comparison in place of the subsequent message.

According to a second embodiment, there is provided a method for communicating parity information to enable a communication device to reconstruct a message that was transmitted to it by another communication device but that it did not receive successfully, the method comprising: transmitting a first parity message to the communication device for a group of one or more messages transmitted to it by the other communication device, the parity message including parity information from which the communication device can reconstruct the one or more messages; and transmitting a second parity message to the communication device for a group of one or more subsequent messages transmitted to it by the other communication device, the second parity message being formed to overlap the first parity message by including in the second parity message parity information in respect of at least one message for which parity information is included in both the first and second parity messages, the method further comprising a forming each configured to form each of the multiple parity messages using a different error-correcting code.

According to a comparative example, there is provided a method for decoding a parity message from which one or more messages that were transmitted but not successfully received may be reconstructed, the parity message including parity information formed by applying a multiple different systematic block codes to the transmitted messages and each of said systematic block codes being represented as a matrix comprising an identity portion and a code portion, the method comprising: forming a decode matrix comprising: (i) an identity portion equal to the number of data symbols to be decoded in the parity message; and (ii) the code portions of each of the systematic block codes that were used to form the parity information; and decoding the parity message using the decode matrix.

The method may comprise identifying any data symbols that were not successfully received and deleting portions of the matrix that correspond to those symbols.

The method may comprise inverting the decode matrix.

The method may comprise multiplying the inverted matrix with data symbols that were successfully received to reconstruct the messages that were transmitted but not successfully received.

The method may comprise determining combinations of data symbols that are commonly not successfully received.

The method may comprise generating a decode matrix for each of the determined combinations and storing that decode matrix for decoding future parity messages.

According to a comparative example, there is provided an apparatus for decoding a parity message from which one or more messages that were transmitted but not successfully received may be reconstructed, the parity message including parity information formed by applying a multiple different systematic block codes to the transmitted messages and each of said systematic block codes being represented as a matrix comprising an identity portion and a code portion, the apparatus being configured to form a decode matrix comprising: (i) an identity portion equal to the number of data symbols to be decoded in the parity message; and (ii) the code portions of each of the systematic block codes that were used to form the parity information and decode the parity message using the decode matrix.

The present invention will now be described by way of example with reference to the accompanying drawings. In the drawings:
Figure 1 illustrates the probability of a negative acknowledgement being interpreted as a positive acknowledgement;
Figure 2 illustrates an example of a communication device;
Figure 3 illustrates a message that was not successfully received;
Figure 4 illustrates a packet erasure channel;
Figure 6 illustrates the effect of a systematic block code;
Figure 7 illustrates the recovery of a missing message using a parity message;
Figure 8 illustrates a run of parity messages;
Figure 9 illustrates overlapping block codes;
Figure 10 illustrates the recovery of data symbols using a systematic block code;
Figure 11 illustrates the recovery of data symbols using a rolling systematic block code;
Figure 12 illustrates an example of a decoding process;
Figure 13 illustrates an example of a decoder;
Figure 14 illustrates an example of a parity system in practice;
Figure 15 illustrates overlapping, underdetermined systematic blocks; and
Figure 16 illustrates a packet delay channel.

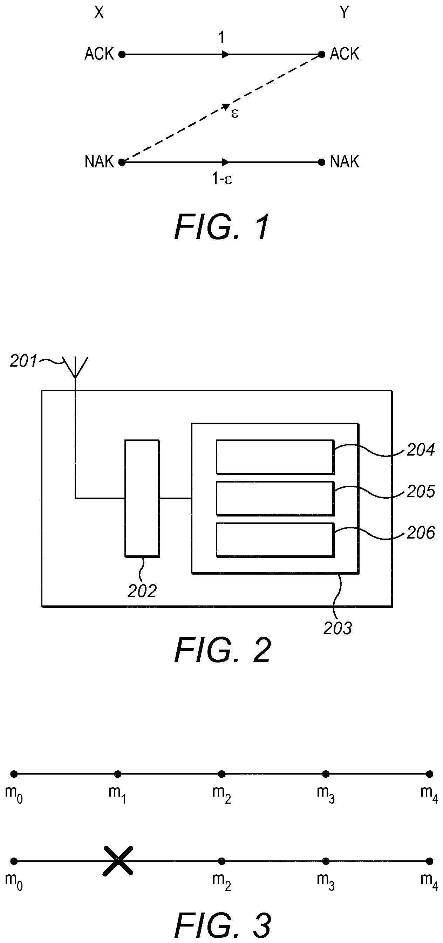

In a probabilistic acknowledgement system, a communication device that transmits a message to another device is not guaranteed to get a reliable acknowledgement for a received message; instead, it may receive a false acknowledgement with probability ε. This is shown in Figure 1. Figure 1: negative acknowledgements (NAK) may (with probability *ε*) be interpreted as positive acknowledgements (ACK) by a communication device that receives the acknowledgement. Similarly, a positive acknowledgement (ACK) may be lost or interpreted as a negative acknowledgement (NAK).

An example of a communication device is shown in Figure 2. The communication device is configured for wireless communication. It comprises an antenna 201 and a radio frequency unit 202. It also comprises a baseband processor 203, which may incorporate a parity information generator 204, a NACK identification unit 205 and a parity message formation unit 206 for putting together the parity messages for transmission.

The communication device may be configured so that the parity messages generated by the parity message formation unit relate to overlapping windows of messages transmitted by the device. The communication device may therefore be configured to form a parity message that relates to one window of transmitted messages to include parity information for one or more messages in a previous window of transmitted messages (and which was included in a previous parity message relating to that window).

The communication device described above may enable a communication network that utilises probabilistic acknowledgements or unreliable acknowledgements to nonetheless provide a reliable data transfer stream with very low overhead.

The structures shown in Figure 2 (and indeed all block apparatus diagrams included herein) are intended to correspond to a number of functional blocks in an apparatus. This is for illustrative purposes only. Figure 2 is not intended to define a strict division between different parts of hardware on a chip or between different programs, procedures or functions in software. In some embodiments, some or all of the algorithms described herein may be performed wholly or partly in hardware. In many implementations, the parity information generator, NACK identification unit and parity message formation unit may be implemented by a processor acting under software control (e.g. the base band processor shown in Figure 2 or a more general CPU of a communication device). Any such software is preferably stored on a non-transient computer readable medium, such as a memory (RAM, cache, FLASH, ROM, hard disk etc) or other storage means (USB stick, FLASH, ROM, CD, disk etc).

The description below focusses on an implementation in which a base station generates probabilistic acknowledgements or unreliable acknowledgements. This is because using a probabilistic data structure to transmit acknowledgements is likely to be of particular use to a base station, which will typically have large numbers of messages to acknowledge. Thus the description below also focusses on a communication terminal being the device that transmits parity messages. This is for the purposes of example only and it should be understood that the principles and techniques described below might be implemented by any communication device and is not limited to any particular device nor to devices playing a particular role in a communication network.

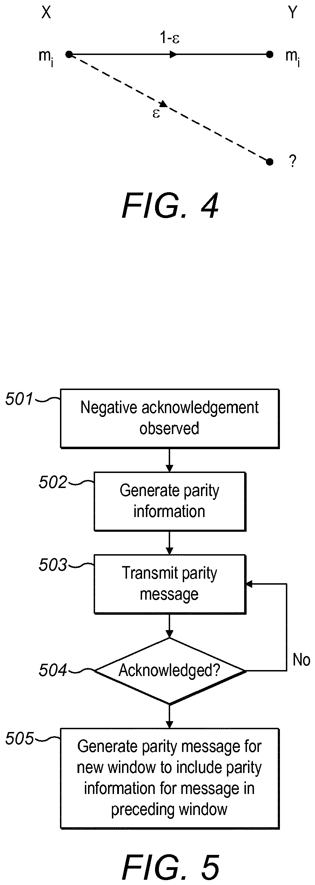

Messages will tend to become lost rarely, when two conditions occur simultaneously: they are not successfully received, and they are also falsely acknowledged. This is illustrated in Figure 3, which shows messages m0...m4 being transmitted by a terminal. All of these messages are apparently acknowledged but m1 was not successfully received. The terminal also received a false positive acknowledgement for this message. Therefore, the receiving device cannot recover the message m1. This effect (i.e. messages becoming lost) forms a packet erasure channel, as shown in Figure 4: with a probability of *ε*, message mᵢ will be erased.

The base station may acknowledge streams of messages rather than individual messages. The acknowledgment may identify the successfully received messages with some degree of ambiguity. Acknowledging a stream of messages means that a message cannot be acknowledged until every previous message (within some window) has been received. It would be very inefficient to merely repeat every past message until an acknowledgement has been received. Instead, a method is required to efficiently recover any missing previous message. Ideally, if the terminal sends k messages plus d retransmissions, the base station should only need to receive k arbitrarily-chosen packets before being able to recover the complete message stream.

A method is described below and illustrated in Figure 5 for generating a reliable message stream. First a negative acknowledgement is observed by the terminal (step 501). It then generates a parity information to enable the base station to recover the missing message (step 502). The parity information is preferably constructed using a systematic, linear, maximum-distance-separable block code. In a typical radio system, error-correcting codes such as systematic block codes are used to give a pre-set level of reliability with a pre-set level of overhead. An overhead may be applied to every message (or block of messages). In the method described herein, no unnecessary overhead is applied and the number/length of transmissions is minimized.

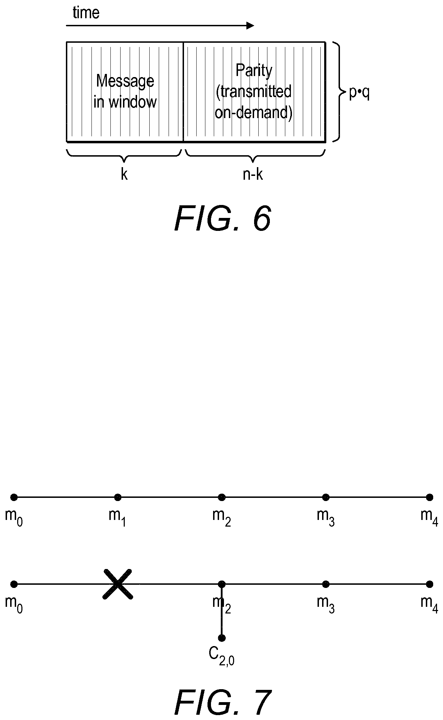

A reason for choosing a systematic code is that the messages themselves form part of the final encoding, as shown in Figure 6. The block code is preferably maximum-distance-separable, such that exactly k packets need to be successfully received to reconstruct k original information packets. Finally, the code should ideally be low-rate, so that a large number of independent parity packets can be generated. A low-rate Reed-Solomon code would meet these requirements.

The parity information could alternatively be generated with other error-correcting codes. A continuous code (such as a convolutional code, which may be systematic) would be an efficient choice. A combination of several different error-correcting codes could also be used.

As shown in Figure 6, messages within a particular block or window (i.e. that have been already transmitted) form part of the code, if a systematic code is used. Up to n-k parity messages can be transmitted, to recover any of the k messages that might be erased (i.e. messages that are known to be missing). Each message is of length up to p•q, where q is the symbol size and p is the number of symbols per message.

One approach for generating the parity information is to run a single block code over the entire contents of the messages in the window; another approach is to run an interleaved Reed-Solomon code over the messages in the window. A preferred approach is to run a separate, parallel block code instance for each symbol of message payload. If the symbol size is 1 byte, and the longest message is p bytes, then p separate parallel block codes could be constructed (the vertical axis in Figure 6). For example, a (255, 127) Reed Solomon code (which has 8-bit symbols) creates 128 parity symbols for 127 data symbols. This allows p parallel Reed Solomon codes to be constructed across a window of 127 messages. Each packet contains p symbols (one symbol from each parallel Reed-Solomon code). With this RS code, up to 128 unique parity messages could be sent to recover missing messages. A missing message may result in a symbol being marked as erased in each code's data stream before the decoding stage (see below).

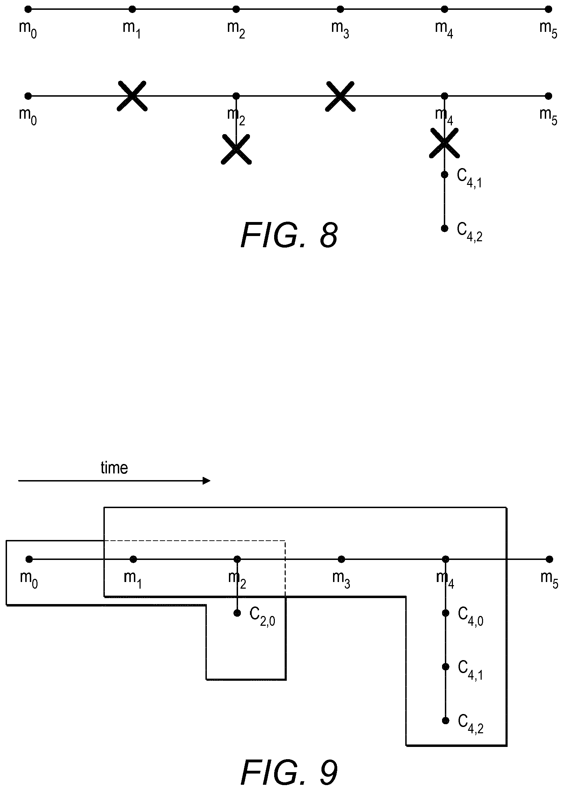

The terminal then transmits a parity message containing parity information for the messages in the given window (step 503). This is shown in Figure 7. The message m1 is lost, but recovered using the coded parity packet c_{2,0} (generated from all messaged up to and including m2). The terminal may repeatedly send new parity information packets to the base station until the base station acknowledges all the messages in the window (step 504). Each parity message is labelled with the latest message sequence number used in its generation, and an index identifying the particular parity message. This procedure is shown in Figure 8: m1, c_{2,0}, m3 and c_{4,0} are lost but the parity information in c_{4,1} and c_{4,2} allows all the messages to be reconstructed.

A problem with unreliable acknowledgements is that the terminal might stop sending parity messages too early. A false positive acknowledgement on a parity packet would cause the next message to be transmitted, before all the messages in the previous window have been received successfully. This generates a new window of messages. For example, in Figure 7: parity packet c_{2,0} might be falsely acknowledged, causing the transmitter to move onto m3 before m2 has been successfully transferred.

This problem may be addressed using a block code constructed over overlapping sets of messages, such as that shown in Figure 9. In this example, two systematic Reed-Solomon codes (which may be identical) share a subset of input messages. Thus their parity packets can be used together to efficiently recover all messages. The result is that, even if a message is falsely acknowledged, subsequent parity messages will include parity information enabling the base station to reconstruct that message. Thus the terminal transmits a parity message for a new window to include parity information for at least one message that was actually part of a previous window (step 505).

Thus, with a moderately sized window of messages, a reliable, lossless message stream can be created, even from highly error-prone acknowledgements.

Another aspect of this method is a "rolling" variant of a systematic code such as a Reed-Solomon code. The base station is preferably configured to decode messages using code symbols constructed from distinct but overlapping sets of messages. It is possible to combine these parity messages from overlapping runs of the error-correcting code. The result is that an "early-terminating" run of parity messages does not waste resources. An efficient decoder can be constructed for this rolling block code by making use of the techniques outlined below.

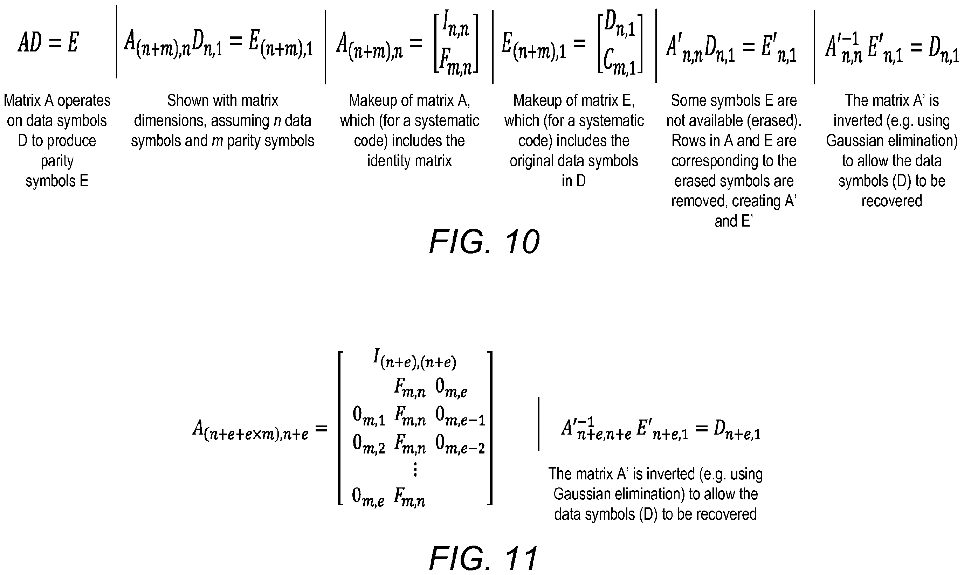

A decoder capable of efficiently recovering erased messages can be constructed using matrix inversion. According to this method, a generator matrix A is constructed representing the conversion of data symbols into data-and-checksum symbols (mᵢ and cᵢ) in a finite field. For a standard Reed-Solomon block code this takes the form of the identity matrix, combined with the code's Vandermonde matrix F, as shown in Figure 10.

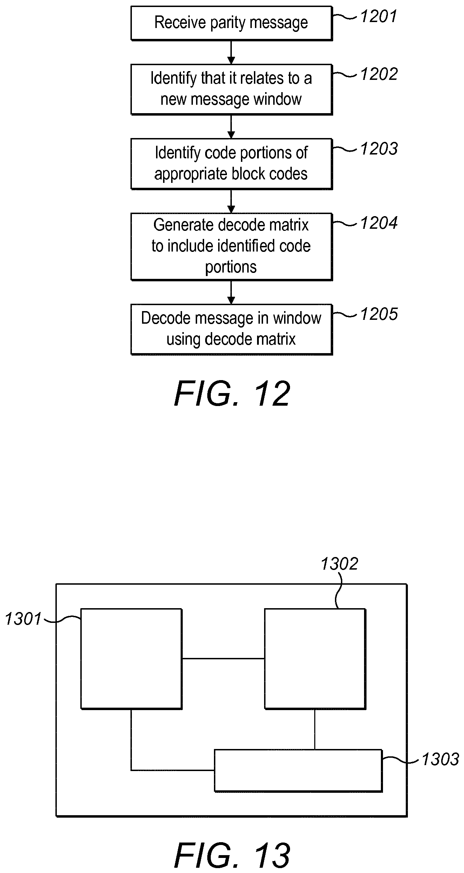

To decode the rolling Reed-Solomon code, the generator matrix A is enlarged and modified (Figure 11). Each time a parity packet is generated from a new block of messages, another copy of the Vandermonde matrix F is inserted into matrix A, with zero-padding. In the example of Figure 11 the number of data symbols in each Reed-Solomon block is n, the number of different Reed-Solomon blocks is e and the number of parity symbols per Reed Solomon block is m. After rows corresponding to erasures have been removed, A' is a square n+e by n+e matrix. An overview of this process is shown in Figure 12.

The inverted matrix A'⁻¹ does not depend upon the received symbols E' but only upon which messages are available (because the locations of erased symbols determine the rows that should be deleted). For each data symbol that has been erased, a single row (a) of the matrix A'⁻¹ is required to recover the data symbol. This is because k packets need to be received in order to reconstruct k original information packets. These rows can be pre-calculated for each likely combination of erased symbols. Using pre-calculated rows, the decoder can operate very efficiently since the remaining decoding operation is very fast, requiring n+e multiplications and n+e-1 additions in a finite field.

An example of a decoding apparatus is shown in Figure 13. The apparatus comprises a success unit 1301 configured to identify which messages have been successfully received by a communication device, a matrix generator 1302 configured to generate an appropriate decode matrix given the block codes that were used to form the parity messages and a decode unit 1303 configured to apply the decode matrix (or more specifically its inverse) to the received data symbols.

The decoding apparatus shown in Figure 13 might be implemented as part of a communication device such as a base station or terminal.

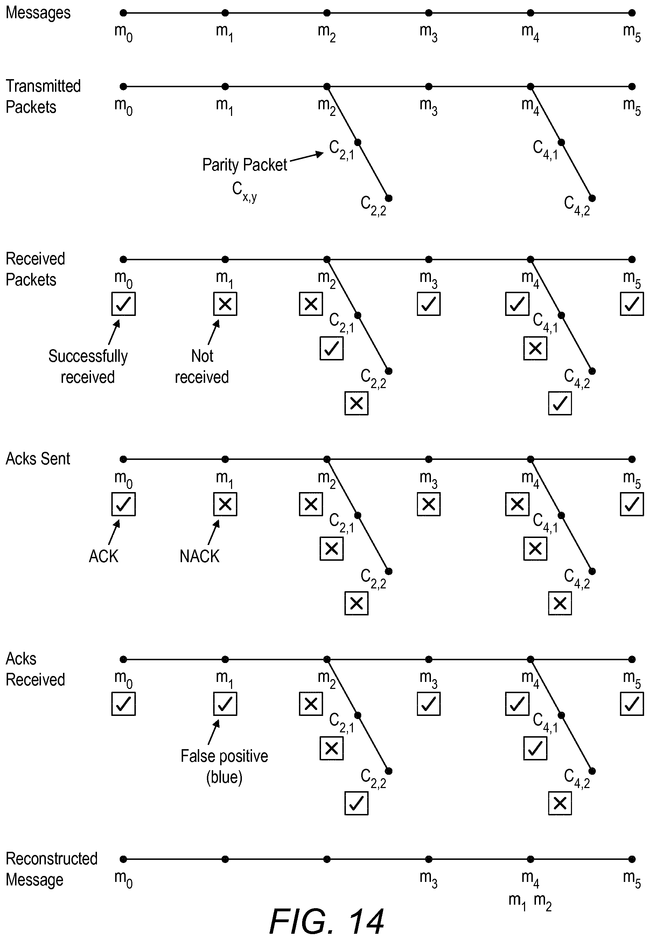

One example of the application of this method is shown in Figure 14. The sequence of events is as follows:
Line 1: The terminal occasionally has new messages to send.
Line 2: The terminal sends the messages in packets. It sometimes sends parity packets, constructed from all previous messages up to that point.
Line 3: The base station receives some of the packets successfully.
Line 4: The base station will only send an ACK if all previous messages have been received/reconstructed successfully.
Line 5: The terminal sees these ACKS, but sometimes sees an incorrect ACK (false positive). It sends parity packets when it thinks it has seen a NACK.
Line 6: The base station eventually is able to reconstruct all the past messages.

Another example of the application of this method is shown in Figure 14. In this example, there are three overlapping Reed Solomon (RS) blocks, constructed from a) m₀ to m₂, b) m₁ to m₄, c) m₂ to m₅. There are six messages (m₀ to m₅), and six correctly received packets (m₀, c_{2,0}, m₄, c_{4,2}, c_{5,0} and c_{5,2}). Each RS block is individually underdetermined, but the combination of all RS blocks into a rolling RS code allows all messages m₀ to m₅ to be recovered.

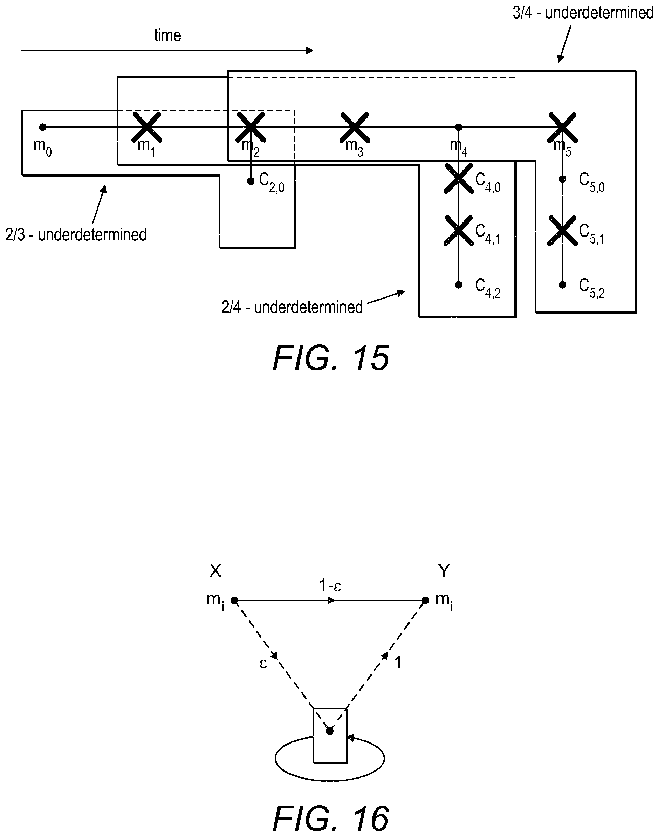

The method described allows most messages (that are successfully delivered) to be decoded instantly but for missing messages to be filled in at a later time (with latency that can be varied according to the terminal and the importance of the particular messages). This forms a packet-delay channel, as shown in Figure 15: with a probability *ε*, a message mᵢ will be delayed before delivery.

Using the reliable data stream that has been constructed, higher capacity can be achieved in a cell. For example, if the transmission of probabilistic acknowledgements is the limiting factor, then two factors improve the capacity in the network.

Firstly, the reliability of the acknowledgements can be decreased, since it would take a large number of consecutive false acknowledgements for any messages to be lost (by falling out of the retransmission-coding window). For example, a high 50% false positive acknowledgement probability (1 bit per message) may correspond to a negligibly low probability of a message being lost when a suitable-sized window of messages is used.

Secondly, the number of messages that are acknowledged can be reduced. If the acknowledgement channel is the limiting factor, only a subset of messages need to trigger an acknowledgement. For example, if every tenth message triggers an acknowledgement and the false positive acknowledgement rate is 15% (∼4 bits per acknowledged message), then there is still an extremely low probability of a message being lost. This means that the cell capacity is increased considerably, since only 0.4 acknowledgement bits per message is sufficient to yield a negligibly low packet loss rate. This effect can be magnified by using a larger window size (i.e. larger block code). For example, the RS (65535, 1023) code would allow 1023 messages to be retained in the window, while being able to generate 64512 unique parity packets - effectively preventing any repetition of parity packets (a rateless code).

Since the data stream is now reliable, the terminal might use compression in the uplink to further increase capacity. The terminal might designate some messages as being "key". These messages could be transferred with high reliability, e.g. by transmitting them multiple times/requesting that the base station acknowledge them unambiguously. These "key" messages (K) can form a base against which future messages (F) are compared. The terminal may exploit any similarity in the messages K and F to produce a compressed version of message F for transmission. Since K was transferred with high reliability, message F can be instantly decompressed even if intervening messages have become lost.

The reliable data stream also provides protection against malicious terminals. Malicious terminals might transmit "incorrect" packets, pretending to originate from the terminal. But the receiver would observe that the received messages are inconsistent (e.g. by receiving enough messages to observe an inconsistency, or by a message authentication failure), and use the error-correction properties of the block code to remove the malicious messages. This method is especially applicable with the probabilistic acknowledgement scheme, which can acknowledge a (potentially secure) hash of the contents of all past messages. In this case, the true terminal will continue transmitting parity packets until it receives a valid acknowledgement.

The technique (to build a reliable data stream upon the packet erasure channel) can be applied to any system including an unreliable acknowledgement channel. For example, the method can be used where acknowledgement messages may become lost or otherwise give unreliable information.

If there is no acknowledgement channel, the rolling parity scheme has other applications. For example, it can be used to provide a low-latency streaming service with good reliability. For example, the terminal might send new parity packets at a predetermined rate, interleaved with new data packets. The terminal is able to send plaintext messages (that can be immediately decoded), with no added error-correction latency. If packets are missing, the interleaved parity packets can be used to recover the stream with very low latency. The base station does not have to wait for the end of a code block, but can immediately decode the stream when enough parity packets have been successfully received.

The scope of protection of the present invention is defined by the independent claims.

## Claims

1. A communication device configured to:
transmit a first parity message to another communication device for a group of one or more messages that the communication device has transmitted to the other communication device, the parity message including parity information from which the other communication device can reconstruct the one or more messages; and
transmit a second parity message to the other communication device for a group of one or more subsequent messages that the communication device has transmitted to the other communication device, the communication device being configured to form the second parity message to overlap the first parity message by including in the second parity message parity information in respect of at least one message for which parity information is included in both the first and second parity messages, **characterized by** the communication device being configured to form each of the multiple parity messages using a different error-correcting code.

2. A communication device as claimed in claim 1, configured to periodically:
identify one or more messages that it has transmitted to the other communication device and for which it has not received an acknowledgement; and
transmit a parity message for the group of identified messages.

3. A communication device as claimed in any preceding claim, configured to form the parity information such that it includes information from each message in a group of messages.

4. A communication device as claimed in any preceding claim, configured to form the parity information using a block code that is maximum-distance-separable.

5. A communication device as claimed in any preceding claim, configured to transmit multiple parity messages in respect of the same group of messages.

6. A communication device as claimed in any preceding claim, configured to transmit multiple parity messages until an acknowledgement is received from the other communication device for the group of messages.

7. A communication device as claimed any preceding claim, configured to designate a message as a key message and transmit a message that is designated as a key message with higher reliability than a message that is not designated as a key message.

8. A communication device as claimed in any preceding claim, configured to generate a comparison with the key message and transmit that comparison in place of a subsequent message.

9. A method for communicating parity information to enable a communication device to reconstruct a message that was transmitted to it by another communication device but that it did not receive successfully, the method comprising:
transmitting a first parity message to the communication device for a group of one or more messages transmitted to it by the other communication device, the parity message including parity information from which the communication device can reconstruct the one or more messages; and
transmitting a second parity message to the communication device for a group of one or more subsequent messages transmitted to it by the other communication device, the second parity message being formed to overlap the first parity message by including in the second parity message parity information in respect of at least one message for which parity information is included in the first and second parity messages, the method **characterized by** forming each configured to form each of the multiple parity messages using a different error-correcting code.

## Patentansprüche

1. Kommunikationsgerät, konfiguriert zum:
Übertragen einer ersten Paritätsnachricht an ein anderes Kommunikationsgerät für eine Gruppe von einer oder mehr Nachrichten, die das Kommunikationsgerät an das andere Kommunikationsgerät übertragen hat, wobei die Paritätsnachricht Paritätsinformation enthält, aus der das andere Kommunikationsgerät die eine oder mehr Nachrichten rekonstruieren kann; und
Übertragen einer zweiten Paritätsnachricht an das andere Kommunikationsgerät für eine Gruppe von einer oder mehr nachfolgenden Nachrichten, die das Kommunikationsgerät an das andere Kommunikationsgerät übertragen hat, wobei das Kommunikationsgerät zum Ausbilden der zweiten Paritätsnachricht zum Überdecken der ersten Paritätsnachricht durch Beinhalten in der zweiten Paritätsnachricht von Paritätsinformation bezüglich mindestens einer Nachricht, für die Paritätsinformation sowohl in der ersten als auch der zweiten Paritätsnachricht beinhaltet ist, konfiguriert ist, **dadurch gekennzeichnet, dass** das Kommunikationsgerät zum Ausbilden von jeder der mehreren Paritätsnachrichten unter Benutzung eines unterschiedlichen Fehlerkorrekturcodes konfiguriert ist.

2. Kommunikationsgerät nach Anspruch 1, konfiguriert zum periodischen Identifizieren von einer oder mehr Nachrichten, die es an das andere Kommunikationsgerät übertragen hat und für die es keine Bestätigung empfangen hat; und
Übertragen einer Paritätsnachricht für die Gruppe von identifizierten Nachrichten.

3. Kommunikationsgerät nach einem der vorhergehenden Ansprüche, konfiguriert zum derartigen Ausbilden der Paritätsinformation, dass sie Information von jeder Nachricht in einer Gruppe von Nachrichten beinhaltet.

4. Kommunikationsgerät nach einem der vorhergehenden Ansprüche, konfiguriert zum Ausbilden der Paritätsinformation unter Benutzung eines Blockcodes, der über maximale Distanz trennbar ist.

5. Kommunikationsgerät nach einem der vorhergehenden Ansprüche, konfiguriert zum Übertragen von mehreren Paritätsnachrichten bezüglich derselben Gruppe von Nachrichten.

6. Kommunikationsgerät nach einem der vorhergehenden Ansprüche, konfiguriert zum Übertragen von mehreren Paritätsnachrichten, bis eine Bestätigung vom anderen Kommunikationsgerät für die Gruppe von Nachrichten empfangen wird.

7. Kommunikationsgerät nach einem der vorhergehenden Ansprüche, konfiguriert zum Designieren einer Nachricht als eine Schlüsselnachricht und Übertragen einer Nachricht, die als eine Schlüsselnachricht designiert ist, mit höherer Zuverlässigkeit als eine Nachricht, die nicht als eine Schlüsselnachricht designiert ist.

8. Kommunikationsgerät nach einem der vorhergehenden Ansprüche, konfiguriert zum Erstellen eines Vergleichs mit der Schlüsselnachricht und Übertragen des Vergleichs anstelle einer nachfolgenden Nachricht.

9. Verfahren zum Übermitteln von Paritätsinformation, um es einem Kommunikationsgerät zu ermöglichen, eine Nachricht zu rekonstruieren, die durch ein anderes Kommunikationsgerät an dieses übertragen wurde, die es jedoch nicht erfolgreich empfangen hat, das Verfahren aufweisend:
Übertragen einer ersten Paritätsnachricht an das Kommunikationsgerät für eine Gruppe von einer oder mehr Nachrichten, die durch das andere Kommunikationsgerät an dieses übertragen wurde, wobei die Paritätsnachricht Paritätsinformation enthält, aus der das Kommunikationsgerät die eine oder mehr Nachrichten rekonstruieren kann; und
Übertragen einer zweiten Paritätsnachricht an das Kommunikationsgerät für eine Gruppe von einer oder mehr nachfolgenden Nachrichten, die durch das andere Kommunikationsgerät an dieses übertragen wurde, wobei die zweite Paritätsnachricht zum Überdecken der ersten Paritätsnachricht durch Beinhalten in der zweiten Paritätsnachricht von Paritätsinformation bezüglich mindestens einer Nachricht, für die Paritätsinformation sowohl in der ersten als auch der zweiten Paritätsnachricht beinhaltet ist, ausgebildet wird, wobei das Verfahren durch Ausbilden von jeder konfiguriert, um jede der mehreren Paritätsnachrichten unter Benutzung eines unterschiedlichen Fehlerkorrekturcodes auszubilden, gekennzeichnet ist.

## Revendications

1. Dispositif de communication configuré pour :
transmettre un premier message de parité à un autre dispositif de communication pour un groupe d'un ou de plusieurs messages que le dispositif de communication a transmis à l'autre dispositif de communication, le message de parité incluant des informations de parité à partir desquelles l'autre dispositif de communication peut reconstruire les un ou plusieurs messages ; et
transmettre un second message de parité à l'autre dispositif de communication pour un groupe d'un ou de plusieurs messages ultérieurs que le dispositif de communication a transmis à l'autre dispositif de communication, le dispositif de communication étant configuré pour former le second message de parité pour chevaucher le premier message de parité en incluant dans le second message de parité des informations de parité en référence à au moins un message à partir duquel des informations de parité sont incluses à la fois dans le premier et le second message de parité, **caractérisé en ce que** le dispositif de communication est configuré pour former chacun des multiples messages de parité à l'aide d'un code correcteur d'erreurs différent.

2. Dispositif de communication selon la revendication 1, configuré pour périodiquement :
identifier un ou plusieurs messages qu'il a transmis à l'autre dispositif de communication et pour lesquels il n'a pas reçu d'accusé réception ; et
transmettre un message de parité pour le groupe de messages identifiés.

3. Dispositif de communication selon l'une quelconque des revendications précédentes, configuré pour former les informations de parité de sorte qu'elles incluent des informations issues de chaque message dans un groupe de messages.

4. Dispositif de communication selon l'une quelconque des revendications précédentes, configuré pour former les informations de parité à l'aide d'un code de bloc qui peut être séparé d'une distance maximale.

5. Dispositif de communication selon l'une quelconque des revendications précédentes, configuré pour transmettre de multiples messages de parité en référence au même groupe de messages.

6. Dispositif de communication selon l'une quelconque des revendications précédentes, configuré pour transmettre de multiples messages de parité jusqu'à ce qu'un accusé réception soit reçu en provenance de l'autre dispositif de communication pour le groupe de messages.

7. Dispositif de communication selon l'une quelconque des revendications précédentes, configuré pour désigner un message en tant que message clé et transmettre un message qui est désigné en tant que message clé avec une fiabilité plus élevée qu'un message qui n'est pas désigné en tant que message clé.

8. Dispositif de communication selon l'une quelconque des revendications précédentes, configuré pour générer une comparaison avec le message clé et transmettre cette comparaison à la place d'un message ultérieur.

9. Procédé de communication d'informations de parité pour permettre à un dispositif de communication de reconstruire un message qui lui a été transmis par un autre dispositif de communication mais qu'il n'a pas reçu avec succès, le procédé comprenant :
la transmission d'un premier message de parité au dispositif de communication pour un groupe d'un ou de plusieurs messages qui lui ont été transmis par l'autre dispositif de communication, le message de parité incluant des informations de parité à partir desquelles le dispositif de communication peut reconstruire les un ou plusieurs messages ; et
la transmission d'un second message de parité au dispositif de communication pour un groupe d'un ou de plusieurs messages ultérieurs qui lui ont été transmis par l'autre dispositif de communication, le second message de parité étant formé pour chevaucher le premier message de parité en incluant dans le second message de parité des informations de parité en référence à au moins un message pour lequel des informations de parité sont incluses dans les premier et second messages de parité, le procédé étant **caractérisé par** la formation de chaque configuré pour former chacun des multiples messages de parité à l'aide d'un code correcteur d'erreurs différent.
